# EUROPEAN PATENT APPLICATION

(11) **EP 2 242 115 A2**
(43) Date of publication of application: **20.10.2010**
(21) Application number: 10160212.6
(22) Date of filing: 16.04.2010
(51) Int. Cl.: H01L 31/118, H01L 31/0216

(54) **Light-tight silicon radiation detector**

(30) Priority: 17.04.2009 US 170300 P; 12.04.2010 US 758464
(71) Applicant: Canberra Industries, Inc., Meriden, CT 06450 (US)
(72) Inventor: Evrard, Olivier, Meriden, Connecticut 06450 (US); Keters, Marijke, Meriden, Connecticut 06450 (US)
(74) Representative: Watterson, Peer Marten John

(57) **Abstract**

A light-tight silicon radiation detector. The detector utilizes a silicon substrate (402) having a sensitive volume for the detection of ionizing radiation and a rectifying contact or electrode through which the ionizing radiation may enter. A diffused or boron-implanted p+ layer may act as the rectifying electrode (404) and as an entrance window for the sensitive volume. A first layer of titanium nitride (406) is deposited on the entrance window to prevent light from being admitted to the sensitive volume and to increase the abrasion and corrosion resistance of the detector. Alternatively a titanium nitride layer may be deposited directly on the silicon substrate, said layer acting as a surface barrier or Schottky barrier rectifying contact. A layer of titanium nitride may be deposited on the backside contact wherein this titanium nitride layer serves as an ohmic contact. The second layer may be further utilized as a conductive contact for surface mount connections.

## Description

### BACKGROUND OF THE INVENTION

### 1. Field of the Invention

The present invention relates to ionizing radiation detectors and, more specifically, to materials and processes used in the manufacture of silicon radiation detectors.

### 2. Description of Related Art including information disclosed under 37 CFR 1.97 and 1.98

Silicon radiation detectors have long been used for the detection of ionizing radiation including alpha and beta particles as well X-ray and gamma ray photons. However, these detectors are inherently sensitive to light. Exposure to light results in undesirable leakage current and noise, degrading detector performance often to the point of making them worthless for the detection of ionizing radiation. For this and for other reasons silicon detectors are often operated in a dark environment which may be in the form of a chamber with opaque walls. The chamber may or may not be evacuated depending on the application.

In some applications it is not possible to shield the detectors from ambient light. In such applications it is necessary to use detectors that are de-sensitized to light. In common practice a reflective aluminum layer over the ohmic contact, blocking electrode, or as the entrance window electrode has been used to reflect or block light from the sensitive volume of the detector.

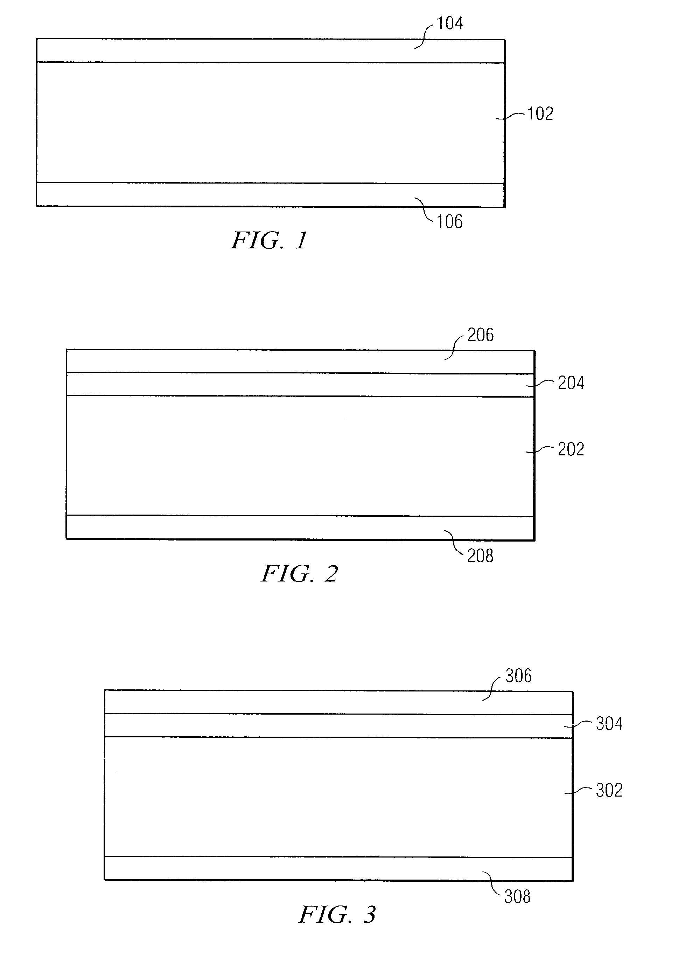

Three examples of common detectors are illustrated in figures 1, 2, and 3. Figure 1 is a simplified illustration of a silicon surface barrier (SSB) detector made from p-type silicon (102). The vapor-deposited aluminum layer (104) on the entrance window acts as a rectifying junction (n+ contact) and it also reflects or blocks ambient light. The opposite side of the detector utilizes an ohmic or blocking electrode (106) as a rear electrical contact. A light-tight structure (108) assists in excluding light from the detector core.

Figure 2 is a simplified illustration of a silicon surface barrier (SSB) detector made from n-type silicon (202). The vapor deposited gold layer (204) on the entrance window serves as a rectifying junction. This layer is made deliberately thin so as not to impede the particles (alphas and betas for example) that the detector is supposed to detect and for this reason it is somewhat transparent to light. A second layer, of vapor deposited aluminum (206), is often added over the gold layer (204) to reflect or block ambient light. Since aluminum is a lightweight metal compared to gold, it does not stop charged particles in the thickness necessary for light rejection. The opposite side of the detector utilizes an ohmic or blocking electrode (208) as a rear electrical contact. A light-tight structure (210) further assists in excluding light from the detector core.

Figure 3 is a simplified illustration of a diffused junction or ion-implanted silicon detector made from n-type silicon (302). The diffused or ion-implanted p+ contact (304) acts as the rectifying junction in this PIN detector. It is coated with a layer of vapor-deposited aluminum (306) which reflects or blocks ambient light. Again, the opposite side of the detector utilizes an ohmic or blocking electrode (308) as a rear electrical contact. A light-tight structure (310) further assists in excluding light from the detector core.

In each of these examples it is shown that the rear contact may be either ohmic or blocking, and the sides and rear of the devices are usually enclosed by a light tight structure. Further, the aluminum layer is typically coated with a layer of some varnish-like substance to provide protection from abrasion and from chemically reactive environments. Since the aluminum layer is relatively soft and aluminum is reactive to water vapor and other chemical impurities that are commonly found in air - particularly in industrial environments - this added varnish layer serves to further protect the detector.

However, the addition of an aluminum and corresponding varnish layer has the undesirable effect of interfering with the detection of ionizing radiation, particularly alphas and other heavy charged particles. These layers capture some of the energy of these particles when the particles pass through them and the energy loss depends upon the angle of incidence. This can lead to peak broadening and tailing as well as to an overall loss in detection efficiency. Typically the aluminum and varnish layers are in the range of 500 to 1000 nanometers in thickness.

An aluminum layer may be added over the entrance window contact of a diffused junction or ion implanted detector, not for light rejection, but for the purpose of reducing the electrical resistance in the path of charges which are formed in the detection process and which must make their way to the outer edge(s) of the device to provide the detector output signal (typically to a charge sensitive preamplifier). Excessive resistance in this conduction path slows down the flow of these charges with a resultant increase in signal risetime and worsening of timing resolution. The aluminum layer is highly conductive compared to typical diffused or ion implanted layers and its addition improves the speed of response of detectors so equipped.

### BRIEF SUMMARY OF THE INVENTION

The present invention provides a light-tight silicon ion implanted, diffused junction, surface barrier, or Schottky barrier detector and method for its creation. The detector utilizes a silicon substrate material having a volume sensitive to ionizing radiation and an entrance window area through which the ionizing radiation may enter. In the case of surface barrier or Schottky barrier detectors a first layer of titanium nitride is deposited on the silicon substrate entrance window as a rectifying junction or blocking electrode. This prevents ambient light from being admitted to the sensitive volume and increases the abrasion and corrosion resistance of the detector. In the case of diffused junction and ion implanted detectors, the TiN layer is deposited on a boron implanted or diffused P+ layer embedded in the surface of the silicon substrate. A second layer of titanium nitride may be deposited on the silicon substrate on another surface, wherein the second titanium nitride layer serves as an ohmic contact. The second layer may be further utilized as a conductive contact while acting at the same time as a light barrier.

These and other improvements will become apparent when the following detailed disclosure is read in light of the supplied drawings. This summary is not intended to limit the scope of the invention to any particular described embodiment or feature. It is merely intended to briefly describe some of the key features to allow a reader to quickly ascertain the subject matter of this disclosure. The scope of the invention is defined solely by the claims when read in light of the detailed disclosure.

### BRIEF DESCRIPTION OF THE SEVERAL VIEWS OF THE DRAWING(S)

The present invention will be more fully understood by reference to the following detailed description of the preferred embodiments of the present invention when read in conjunction with the accompanying drawings, wherein:
**FIG. 1** is a simplified cross-sectional illustration of a typical silicon surface barrier (SSB) detector made from p-type silicon and having a vapor-deposited aluminum layer on the entrance window;
**FIG. 2** is a simplified cross-sectional illustration of a typical SSB detector made from n-type silicon and having a vapor-deposited gold layer on the entrance window, which is protected by an additional aluminum layer;
**FIG. 3** is a simplified cross-sectional illustration of a typical diffused junction or ion-implanted silicon detector made from n-type silicon and having a layer of vapor-deposited aluminum on the entrance window;
**FIG. 4** is a simplified cross sectional illustration of an embodiment of the present invention utilizing a diffused junction or ion-implanted silicon detector made from n-type and having a titanium nitride layer over the entrance window;
**FIG. 5** is a simplified cross-sectional illustration of an embodiment of the present invention made from n-type or p-type silicon and utilizing a titanium nitride layer as a rectifying (entrance window) contact;
**FIG. 6** is a simplified cross-sectional illustration of an embodiment of the present invention utilizing a titanium nitride layer over the rear ohmic, diffused, or implanted contact; and
**FIG. 7** is a simplified cross-sectional illustration of a detector housed within a light-tight structure.

The above figures are provided for the purpose of illustration and description only, and are not intended to define the limits of the disclosed invention. Use of the same reference number in multiple figures is intended to designate the same or similar parts. Furthermore, when the terms "top," "bottom," "first," "second," "upper," "lower," "height," "width," "length," "end," "side," "horizontal," "vertical," and similar terms are used herein, it should be understood that these terms have reference only to the structure shown in the drawing and are utilized only to facilitate describing the particular embodiment. The extension of the figures with respect to number, position, relationship, and dimensions of the parts to form the preferred embodiment will be explained or will be within the skill of the art after the following teachings of the present invention have been read and understood.

### DETAILED DESCRIPTION OF THE INVENTION

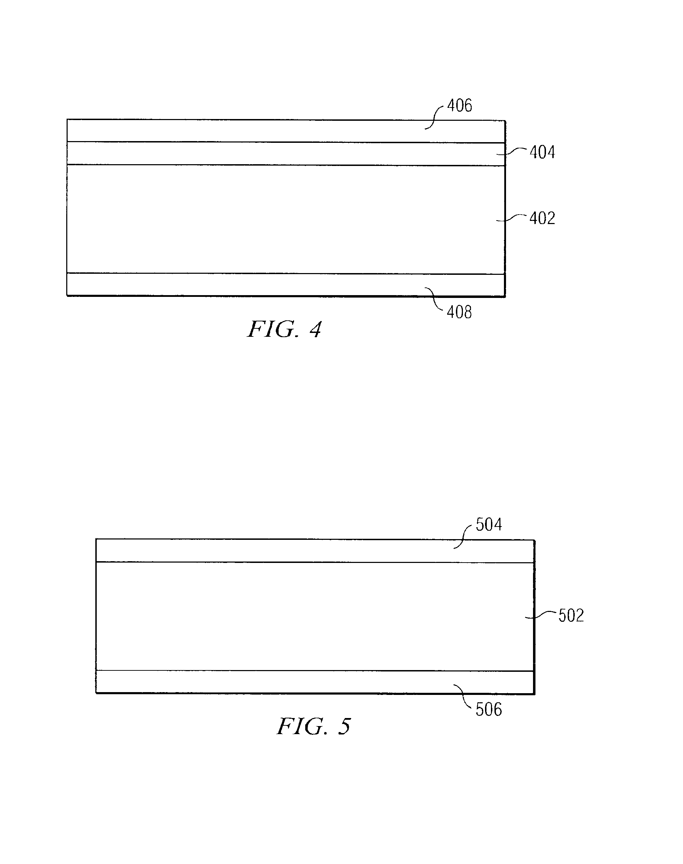

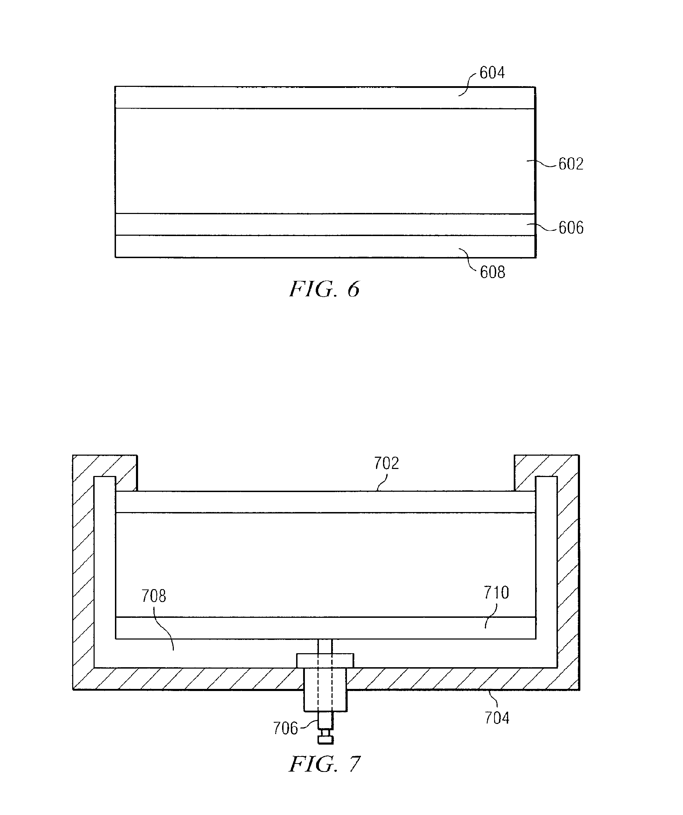

FIG. 4 depicts a first embodiment of the invention. As shown, the detector may be comprised of N-type silicon substrate material, providing a volume sensitive to ionizing radiation. A boron implanted (p+) layer serves as the rectifying junction (404) and as an entrance window for the sensitive volume. Next, a layer of titanium nitride (TiN) (406) is applied by physical vapor deposition (PVD) over the p+ layer. In another embodiment, a second titanium nitride layer may be deposited over the rear blocking contact or electrode to provide additional light-tightness and to act as a rugged contact for wire bonding or surface mount (solder) bonding. A light-tight enclosure (such as the one depicted in FIG. 7) may be used to block light from entering the detector from the sides and rear.

FIG. 5 depicts another embodiment of the invention. As shown, the detector is comprised of an N-type silicon substrate material, providing a volume sensitive to ionizing radiation. A first layer of TiN is applied by physical vapor deposition over the entrance window surface (504). This layer serves at the rectifying contact and provides light rejection as well as physical and chemical protection to the device. In yet another embodiment, second titanium layer may be applied over the rear blocking contact or electrode (506) to provide additional light tightness and to act as a rugged contact for wire bonding or surface mount (solder) bonding. A light-tight enclosure (such as the one depicted in FIG. 7) may also be used to block light from entering the detector from the sides and rear.

Although an N-type silicon substrate is discussed in the above embodiments, it is also possible to utilize a P-type silicon substrate. Another embodiment that utilizes a P-type silicon substrate would require an n+ material rectifying contact layer to achieve the proper biasing, as well as a p+ material ohmic contact layer. One of ordinary skill in the art will appreciate that the embodiments disclosed herein may thus be built upon either N-type or P-type silicon substrates.

The various material layers may be applied to the semiconductor substrate using standard deposition methods. For example, the TiN layer may be deposited using sputter deposition, electron beam deposition (e-beam deposition), chemical vapor deposition (CVD), or Plasma CVD. In the present embodiment, it has been shown that a nominal TiN layer thickness of at least approximately 0.1 µm is preferred to achieve sufficient ambient light blocking ability. If solder bonding is to be performed on a TiN layer junction, then a layer thickness of at least approximately 0.5 µm is preferred. Ideally, the thickness range of the TiN layer will be between 0.1 µm and 2.0 µm.

Rectifying contacts on n-type silicon substrates are typically made from 0.1 µm to 2 µm deep heavily-doped boron profiles that either can be implemented by ion implantation or by diffusion in ovens containing boron nitride disks or gases of the borane family. Ohmic contacts on n-type silicon substrates are typically made from 0.1 µm to 2 µm deep heavily-doped phosphorous profiles that either can be implemented by ion implantation or diffusion in ovens containing P2O5 disks, phosphor-silicate glasses (mixtures of P2O5 and SiO2), or gasses of the phosphine (PH3) family. For p-type silicon, ohmic contacts utilize boron and rectifying contacts utilize phosphorous, applied by the same techniques as described above.

FIG. 6 depicts another embodiment of the present invention, with a layer of TiN (608) applied to the bottom of the ohmic or blocking layer (606) of the detector (602). The rectifying contact layer (604) remains on top, and may or may not be composed of TiN. Use of TiN as an ohmic contact or barrier layer on the bottom of the detector provides several benefits. The TiN material is highly resistant to the corrosive atmospheres commonly found in industrial settings and provides protection from abrasion. The TiN layer also blocks light from entering the sensitive detector volume should be bottom of the detector not otherwise be shielded from light. TiN is also a good electrical conductor, allowing this single layer to serve as a conductive surface mount pad for attachment to a printed circuit board or ceramic substrate.

An added benefit to applying TiN over the entrance window contact of a diffused junction or ion implanted detector is that it reduces the electrical resistance in the path of charges which are formed in the detection process and which must make their way to the outer edge(s) of the device to provide the detector output signal. The reduced resistance provided by this material in this conduction path speeds the flow of these charges and reduces the signal rise time, improving the timing resolution.

FIG. 7 depicts use of a detector within a light-tight housing. As shown, an embodiment of the detector (702) fits within the inner cavity of a housing (704) constructed of light-tight materials. These materials may include polymers, metals, or some combination thereof depending on the requirements of the greater detector device. A feed-through connector (706) provides electrical connectivity to the detector ohmic contact (706) through the bottom of the housing (704). A void space (708) exists between the housing and connector, preventing electrical shorting from occurring between the rectifying layer (702) and ohmic contact (710). This void space may consist of an inert material such as a non-conducting filler or the like.

The foregoing detailed description of the present invention is provided for the purposes of illustration only, and is not intended to be exhaustive or to limit the invention to the precise embodiments disclosed. Accordingly, the scope of the present invention is defined only by the following claims and equivalents.

## Claims

1. A silicon ion implanted detector, the detector comprising:
a silicon substrate material having a sensitive volume for the detection of ionizing radiation and an ion implanted entrance window electrode through which the ionizing radiation may enter the sensitive volume; and
a first layer of titanium nitride deposited on the ion implanted entrance window electrode, wherein the first titanium nitride layer prevents ambient light from being admitted to the sensitive volume and affords chemical and physical protection for the entrance window electrode.

2. The detector of claim 1 wherein the first layer of titanium nitride is at least approximately 0.1 µm in thickness.

3. The detector of claim 1 or claim 2 further comprising:
a second layer of titanium nitride deposited on the bottom of the substrate as a rear blocking electrode.

4. The detector of claim 3 wherein the second layer of titanium nitride is at least approximately 0.1 µm in thickness.

5. The detector of any preceding claim 1, wherein the first titanium nitride layer reduces the spreading resistance in the entrance window contact, thus reducing the signal rise time of the detector and improving the overall timing resolution.

6. A silicon detector, the detector comprising:
a silicon substrate having a sensitive volume for the detection of ionizing radiation; and
a first layer of titanium nitride acting as surface barrier or Schottky barrier rectifying contact.

7. The detector of claim 6 wherein the first layer of titanium nitride is approximately 0.1 µm in thickness.

8. The detector of claim 6 or claim 7 further comprising:
a second layer of titanium nitride deposited on the bottom of the substrate as a rear blocking electrode.

9. The detector of claim 8 wherein the second layer of titanium nitride is at least approximately 0.1 µm in thickness.

10. A silicon detector, the detector comprising:
a silicon substrate having a sensitive volume for the detection of ionizing radiation;
an ion implanted, diffused, surface barrier rectifying entrance window electrode; and
a rear blocking electrode, the rear blocking electrode having a first titanium nitride layer, wherein the first titanium nitride layer protects the detector from physical and chemical reactions, rejects light from the sensitive volume, and serves as a rugged conductive layer for electrical connections.

11. The detector of claim 10 wherein the first titanium nitride layer is at least 0.1 µm in thickness.

12. The detector of claim 10 or claim 11 further comprising:
a second layer of titanium nitride deposited on the top of the substrate as the surface barrier rectifying entrance window electrode.

13. The detector of claim 12 wherein the second layer of titanium nitride is at least approximately 0.1 µm in thickness.

14. The detector of any preceding claim wherein a diffused or boron-implanted p+ layer acts as the rectifying electrode.

15. The detector of any of claims 1, 6 or 10 further comprising a second layer of titanium nitride, said second layer being a conductive contact and a light barrier.
